(19) Europäisches Patentamt / European Patent Office / Office européen des brevets

(11) **EP 2 573 793 A1**

(12) **EUROPEAN PATENT APPLICATION**
published in accordance with Art. 153(4) EPC

(43) Date of publication:
**27.03.2013 Bulletin 2013/13**

(51) Int Cl.:
*H01J 37/143* (2006.01)   *H01J 37/06* (2006.01)
*H01J 37/073* (2006.01)   *H01J 37/18* (2006.01)
*H01J 37/26* (2006.01)

(21) Application number: **11783579.3**

(22) Date of filing: **18.05.2011**

(86) International application number:
**PCT/JP2011/061403**

(87) International publication number:
**WO 2011/145645 (24.11.2011 Gazette 2011/47)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **21.05.2010 JP 2010117317**

(71) Applicant: **Hitachi High-Technologies Corporation
Tokyo 105-8717 (JP)**

(72) Inventors:
• **ONISHI, Takashi
Hitachinaka-shi
Ibaraki 312-8504 (JP)**
• **WATANABE, Shunichi
Hitachinaka-shi
Ibaraki 312-8504 (JP)**
• **ICHIHASHI, Mikio
Nagoya
Aichi 464-8601 (JP)**

(74) Representative: **Calderbank, Thomas Roger
Mewburn Ellis LLP
33 Gutter Lane
London
EC2V 8AS (GB)**

(54) **ELECTRON MICROSCOPE**

(57) In an electron microscope having a magnetic field immersion type cold-FE electron gun, the electron gun and the electron microscope are provided with high observation efficiency and the focal distance of the electron gun does not change during use. The degree of vacuum in the electron gun is improved with a getter pump for stabilization. Further, observation efficiency is improved by cleaning the electron source periodically and returning to recorded optical conditions on the occasion.

*FIG. 2*

EP 2 573 793 A1

## Description

Technical Field

The present invention relates to an electron microscope, and in particular to a cold cathode field-emission (cold-FE) electron gun being used for the electron microscope and generating a high-brightness electron beam.

Background Art

An electron microscope is an observation instrument to obtain a magnified image of a specimen by using an electron beam. The electron microscope mainly includes an electron gun, an electron optical system, a specimen holder, detectors, controllers, and a power source unit.

The electron gun is a device to generate an electron beam. The electron optical system is a device to transport electrons generated in the electric gun to a specimen and irradiate the specimen. The electron optical system plays also the role of focusing the electron beam with an electromagnetic lens and also deflecting the electron beam during the process. The specimen holder is a device to fix a material to be observed, namely a specimen, on an electron beam path in the electron optical system and move the specimen if necessary. The inside of the electron gun and the electron optical system are kept in vacuum in order to get the electron beam through without being interfered with air and, for the purpose, a vacuum pump is provided. An electron beam which scans over is called "probe electron" by using the analogy of a probe to explore a specimen. The probe electron generates reflection electrons, secondary electrons, reflection electrons, transmission electrons, scattering electrons, X-ray, etc. by interaction with atoms in specimen. The detector is a device to detect such electrons and X-rays. Information obtained by the detector is analyzed by the controller, processed as a magnified image and an element composition of a specimen in the state easily-viewable by an operator, and displayed or recorded. The controller further has the role of controlling the power source unit. The power source unit is a device to supply powers for the electron gun, the electron optical system, the detector, etc. and precisely control the operation of the electron gun, the electron optical system, and the detector.

An electron gun plays a significant role for obtaining a more precise magnified image and an element analysis result of a specimen in an electron microscope.

An electron gun generates electrons used for observation as free electrons in a vacuum. The principle in generating electrons varies in accordance with the type of an electron gun. An electron gun accelerates electrons by potential difference and thereby generates the electrons as a group of electrons having kinetic energy, namely as an electron beam. Probe electrons are the electrons obtained by regulating a part of a generated electron beam with apertures or the like and extracting the part. In order to obtain information related to the precise structure of a specimen, a probe electron beam has to be focused to the finest possible extent. A minimum radius of a probe electron beam on a specimen is called "a spot radius" and, in general, more precise information on the structure of a specimen is obtained as a spot radius reduces. Since information on a specimen is obtained by the reaction of probe electrons with atoms in the specimen as stated above, in order to obtain much information for a short period of time, it is desirable to increase the quantity of a probe electron beam per unit time, namely a probe current, as much as possible.

There is a method of increasing the diameter of an aperture to regulate an electron beam and additionally taking in an electron beam coming to a position relatively apart from an optical axis defined as a virtual central axis of an electron beam route as a probe in order to obtain more probe current. This corresponds to a method of additionally taking in the electrons forming relatively large angles to an optical axis in the total quantity of the electrons emitted from an electron source, namely emission current, as probe electrons. An electron beam emitted at large angles however is largely influenced by the aberration of electromagnetic lenses included in an electron gun and an electron optical system, resultantly cannot be finely focused on a specimen, and has a large spot radius. Consequently, the two requirements of the minimization of a spot radius and the increase of probe current are generally in a contradictory relationship.

With regard to the limitation, as a basic property of an electron gun, there is "brightness" defined as an electric current per unit area per solid angle at which a generated electron beam is emitted. The brightness of an electron beam generated by an electron gun is an important property determining the limitations of a spot radius and a probe current and has various values mainly in accordance with the electron beam generation principle of an electron gun.

A cold cathode field-emission (cold-FE) electron gun is an electron gun having a high brightness. The cold-FE electron gun uses a tungsten monocrystal, whose tip is sharpened by electrolytic polishing, as an electron source. On condition that an extraction electrode is installed in proximity to the electron source, when an extraction voltage of several kilovolts is applied between the electron source and the extraction electrode, electric field concentration is caused at the tip of the electron source, a high electric field is generated, and hence electrons are emitted from the electron source by field emission. The relationship between an extraction voltage and an emitted current quantity, namely an emission current, depends on the curvature radius of an electron source tip. Since it is possible to reduce the curvature radius of an electron source tip and assume a small region of around 5 nm as an electron source, a cold-FE electron gun has a very high brightness. Further, since it is unnecessary to heat a cathode in the event of field emission in relation to the principle, the energy width of a generated electron beam is relatively smaller than that of another electron source. This also means that electrons generated by the cold-FE electron gun form an electron beam hardly influenced by color aberration caused by electron energy spread in an electron optical system.

In the cold-FE electron gun, as one of electron gun types used for obtaining a higher brightness and a larger current, there is a magnetic field immersion type cold-FE electron gun. The magnetic field immersion type cold-FE electron gun is an electron gun having not an electrostatic lens of a Butler type or the like but a magnetic lens focusing an electron beam by a magnetic field. By using the magnetic lens instead of the electrostatic lens, an electron beam generated by the electron gun can have a shorter focus and a lower aberration. An advantage of adopting the magnetic field immersion type cold-FE electron gun is that brightness is not caused to deteriorate by the aberration of the electron gun even when a large current is extracted as a probe and, as Patent Literature 1 shows, an electron gun having an electron source placed in a magnetic lens has a smaller aberration and a larger advantage.

In the case of installing the magnetic lens in the vicinity of an electron source, the magnetic lens using a permanent magnet is mostly adopted as the magnetic field generation principle of the magnetic lens. This is because, from the viewpoint of the nature of the electron gun unit in which the electron source is usually placed under a high voltage, it is technically difficult to introduce electric current for an electromagnet in the vicinity of an electron source and consequently difficult to install the electromagnet. Another drawback of the electromagnet is that the coil thereof generates Joule heat and thermal desorption gas in the vicinity of the electron source deteriorates. On the other hand, when the permanent magnet is used as a magnetic field source of the magnetic lens, the electric power source is unnecessary and Joule heat is not generated.

On the other hand, in the magnetic field immersion type cold-FE electron gun, when the permanent magnet is used for focusing an electron beam, an arising drawback is that the point on which the electron beam is focused cannot easily be controlled. The magnetic lens made of a permanent magnet has a constant magnetic field intensity and has a constant strength as the magnetic lens for focusing the electron beam. Here, the electron beam is extracted from the electron source by an extraction electrode and accelerated up to an extraction electrode potential primarily. In the magnetic field immersion type cold-FE electron gun, the electron beam is most affected by the magnetic lens at a primary acceleration stage between the electron source and the extraction electrode. Consequently, optical factors of the electron beam generated by the magnetic field immersion type cold-FE electron gun largely vary in accordance with an extraction voltage. For example, a virtual source position indicating the point on which an electron beam is focused largely moves vertically. The extraction voltage is dependently determined by an emission current or probe current to be obtained and the curvature radius of the electron source tip as stated above and hence it is inconvenient that a virtual source moves in accordance with an extraction voltage. Specifically, it comes to be necessary to readjust the electron gun and the electron optical system so that the electron beam may be focused accurately on a specimen when the extraction voltage is changed.

In general, the field emission of the electron source in the cold-FE electron gun is influenced by the degree of vacuum in the electron gun. The surface of the electron source comprising tungsten monocrystal causes field emission at the highest brightness when the surface thereof is clean. Ordinarily, in the cold-FE electron gun, the electron source is heated for a short period of time before it is used and the surface of the electron source is cleaned by gas molecule desorption caused by heating. This is called flashing. In the cold-FE electron gun, however, generally emission current decreases gradually during the time when it is used for observation. This is because the electron source absorbs gas molecules remaining in a high vacuum and a work function for emitting an electron beam from monocrystal increases. The degree of the decrease is observed by a probe current quantity and measured by time $\tau 30$ spent until the emission current decreases to for example about 30% of the state where the electron source is clean, namely about 30% compared to that immediately after flashing. The attenuation time $\tau 30$ is in the following relationship with the degree of vacuum P around the electron source,

$$\log(\tau_{30}) = A - k\log P$$

A and k are constants determined by the nature of a residual gas, the shape of the electron source, a vacuum measurement position, etc. When the degree of vacuum in the electron gun is low, namely when the quantity of the residual gas is large, a probe current attenuates rapidly. Unless the decrease of the probe current is compensated by the increase of the extraction voltage or the like, the probe current decreases to the extent of not conforming to specimen observation before specimen observation operation is finished. In contrast, when the degree of vacuum in the electron gun is high, namely when the quantity of the residual gas is small, the decrease of the probe current is gradual.

Designers of the cold-FE electron gun have heretofore obtained a degree of vacuum necessary for field emission by pumping a vacuum chamber with an ion pump or the like. In a vacuum region of about $10^{-8}$ Pa or more, however, the pumping speed of the ion pump lowers significantly from the characteristic of the pumping principle. Consequently, as shown in Patent Literature 2, proposed is a pumping method of using an NEG (Non-Evaporable Getter) pump or the like, which is based on the pumping principle of chemically adsorbing gas molecules to the surface of an alloy having chemical activity, together with an ion pump, and the method has been utilized.

Prior Art Literature

Patent Literature

Patent Literature 1: JP-A No. H02-297852
Patent Literature 2: JP-A No. 2005-000916

Disclosure of the Invention

Problem to be solved by the invention

The problem to be solved by the present invention is that, when extraction voltage is changed during observation in an electron microscope equipped with a magnetic field immersion type cold-FE electron gun, the focal distance of the electron gun changes, the readjustment of the electron gun and an electron optical system is required, and observation efficiency (throughput) deteriorates.

Means for solving the problem

The present invention is configured to improve vacuum in the magnetic field immersion type cold-FE electron gun. Further, the most important feature of the present invention is configured to make the readjustment of the electron gun and the electron optical system unnecessary even in long time observation, and to make (high-throughput) observation possible, by cleaning the electron source periodically.

Advantages of the invention

The magnetic field immersion type cold-FE electron gun according to the present invention has a function of increasing the degree of vacuum in an interior thereof and cleaning the electron source and recovering probe current without changing optical conditions during operation. Consequently, a specimen can be observed without the necessity of the readjustment of the electron gun and an electron optical system even in long time measurement.

Brief Description of the Drawings

Fig. 1 is a configuration diagram showing the configuration of an electron microscope.
Fig. 2 is a configuration diagram showing the configuration of an electron gun.
Fig. 3 is a configuration diagram showing the positional relationship between an electron source and a magnetic field distribution of a magnetic lens.
Fig. 4 is a flowchart showing the control procedure of the electron gun in the electron microscope.

Preferred modes of carrying out the present invention

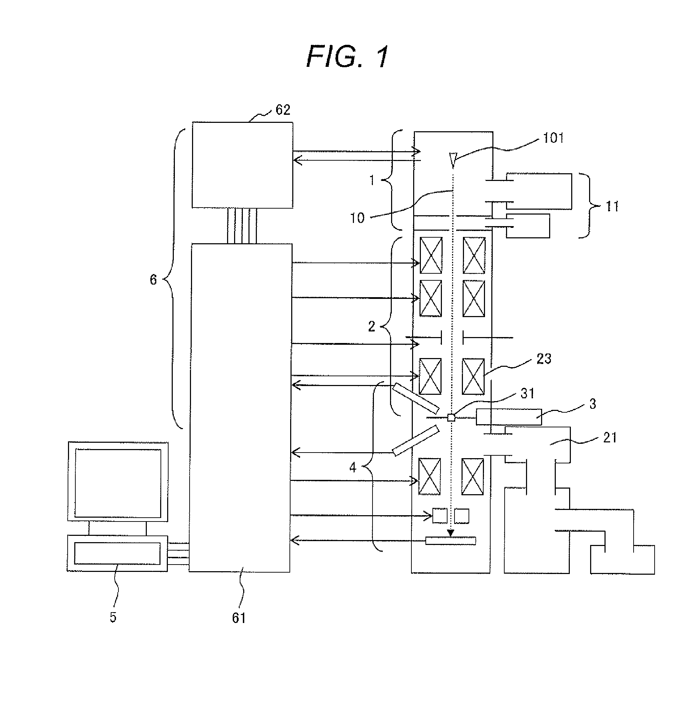

An electron microscope equipped with a magnetic field immersion type cold-FE electron gun is shown in Fig. 1 as an example of an embodiment of the present invention. The electron microscope has an electron gun 1, an electron optical system 2, a specimen holder 3, detectors 4, a controller 5, and a power source unit 6. In Fig, 1, the electron gun 1 and the electron optical system 2 have vacuum evacuation devices 11 and 21 respectively but may sometimes have only one vacuum evacuation device in the case of a small electron microscope ormay sometimes have many segmentalized vacuum evacuation devices.

The electron gun 1 generates an electron beam 10, the electron optical system 2 converges and deflects the electron beam 10, and a specimen 31 is irradiated with the electron beam. The specimen holder 3 retains the specimen 31 and moves, tilts, and exchanges the specimen 31 when needed. The detector 4 measures reflection electrons, secondary electrons, transmission electrons, scattering electrons, X-rays, etc. emitted from the specimen 31. The power source unit 6 supplies electric power to the electron gun 1 and the electron optical system 2, adjusts output, and controls the electron beam to a state required of an operator. Further, it converts information from the detector 4 into digital signals. The controller 5 controls the electron gun 1 and the electron optical system 2 through the power source unit 6, processes information from the detector 4 through the power source unit 6, and displays or records the information in the manner of being viewable by an operator. The power source unit 6 is divided broadly into a control/detection system power source 61 and an electron gun power source 62.

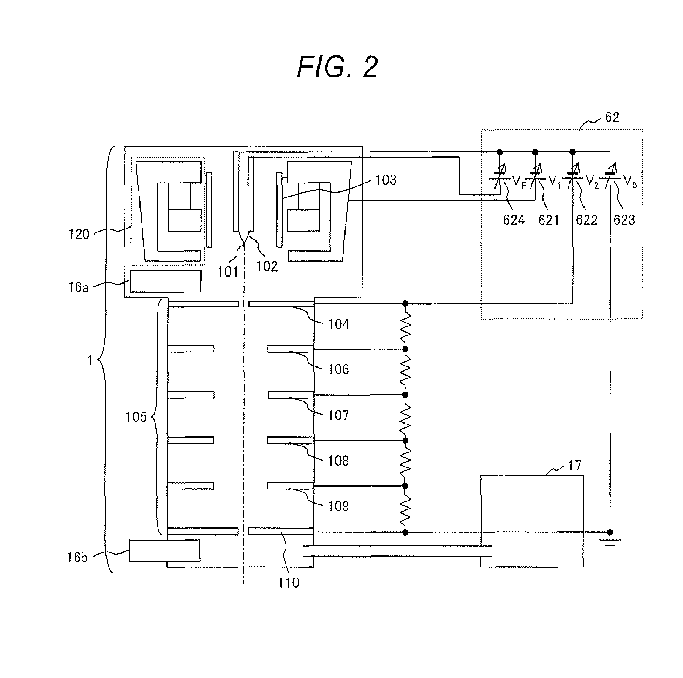

Here, details of a structure of the magnetic field immersion type cold-FE electron gun 1 according to an embodiment of the present invention are shown in Fig. 2. A strong electric field is formed at the tip of an electron source 101 (cold cathode field-emission electron source) by an extraction electrode 103 to which an extraction power source 621 applies an extraction voltage (V1) of several kilovolts. Electrons emitted by the principle of field emission are accelerated by a potential difference (V2-V1) between the extraction voltage (V1) and a voltage (V2) of a focusing electrode 104 generated by a focusing power source 622 and accelerated further during the course of passing through intermediate electrodes 106, 107, 108, and 109 provided in an acceleration tube 105. The electron source 101, the extraction electrode 103, and the focusing electrode 104 are under high voltages of several hundred kilovolts by an acceleration power source 623 and an electron beam is accelerated between them and an anode 110 of the ground potential namely as zero potential.

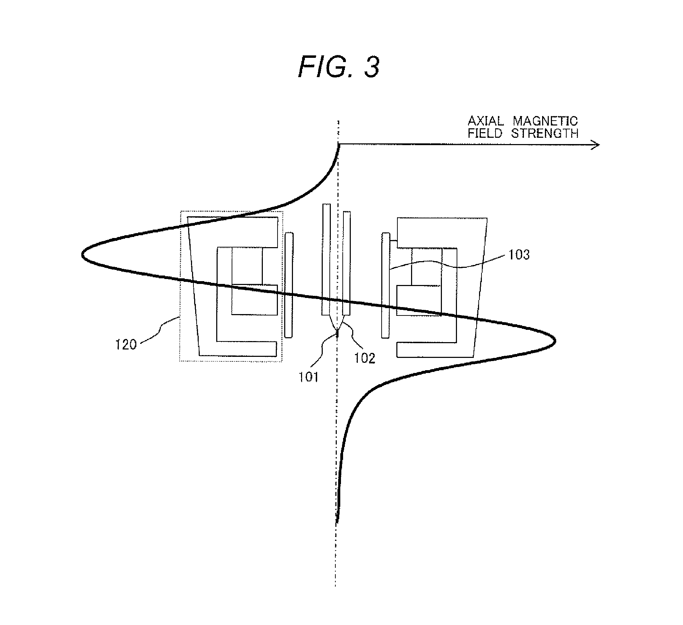

Here, a magnetic lens 120 is one made of a permanent magnet. The magnetic lens generates an axial magnetic field having a bell-shaped strength on a center axis of the electron gun, in which the electron source is located, in a direction parallel with the axis, the axial magnetic field functions as the magnetic lens to focus the electron beam, and thus the electron beam is focused. The strength of the magnetic field generated by the magnetic lens is shown along a horizontal axis in Fig. 3. By vertically moving a relative position between the magnetic lens and the electron source, it is possible to adjust an effect of the magnetic lens on the electron beam so as to be strong (when the electron source is moved upward) or weak (when the electron source is moved downward). Either the electron source may be moved vertically or the magnetic lens may be moved vertically.

Here, the electron source is located at a position physically separated from a ground potential by an acceleration tube and is under a high voltage equivalent to an acceleration voltage. Consequently, an ordinary vacuum pump cannot be placed in the vicinity of the electron source. This is because a power source can hardly be supplied. An ordinary vacuum pump has to be placed around a ground potential. Such an ion pump is shown as 17a in the figure. Meanwhile, a chemical adsorption pump such as an NEG (Non-Evaporable Getter) pump does not require a power source when it is driven and hence can be placed under a high voltage. The distance between the pump and the electron source should be reduced to the maximum possible extent in order to improve the degree of vacuum around the electron source and hence a getter pump 17a is placed in the vicinity of the electron source 11 as shown in Fig. 1.

In such an embodiment, it is possible to improve the degree of vacuum around the electron source in comparison with a conventional magnetic field immersion type cold-FE electron gun and an electron microscope operator can use an electron beam without reducing a probe current for a long period of time (about 30 min. or more) usable for observation. As a result, the electron gun and the electron microscope, which make it possible to reduce the readjustment frequency of the electron gun and the electron optical system and allow stable and highly-efficient (high throughput) observation, can be provided.

By improving the degree of vacuum in the electron gun, stability can be obtained for a long period of probe time and moreover, when observation for a longer period of time is intended, by cleaning the electron source during the use of the electron microscope, the electron gun can be used continuously without the readjustment of the electron gun and the electron optical system.

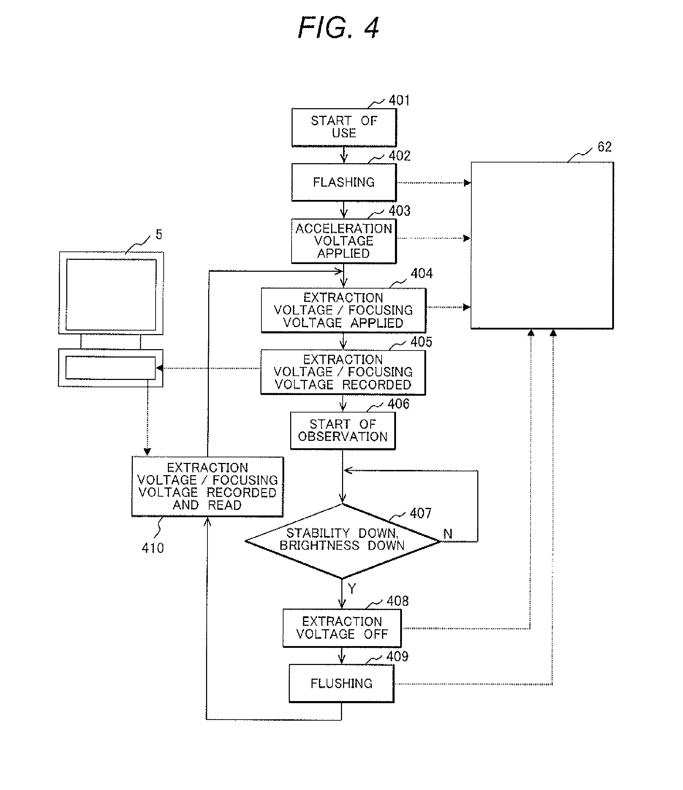

The method is shown as a flowchart in Fig. 4. In the cold-FE electron gun in general, impurity gas molecules are ejected by heating the electron source with filament energization immediately after the beginning of use (Step 401), and thereby a surface of the electron source is cleaned, and the use of an electron beam starts (Step 402). Successively, a high voltage is applied to the electron source (Step 403), an extraction voltage and a focusing voltage are applied so that a necessary probe current may be obtained (Step 404), and successively observation starts (Step 406). Here, a controller 5 stores the applied extraction voltage and focusing voltage at Step 405 before the observation starts. During use, when an operator realizes the decrease of a probe current through information from a probe current monitor or the decrease of the contrast of an observed image (Step 407), the operator sends a command to clean the electron source to the controller (Y branch of Step 407).

The controller 5 controls a power source system 62 and once reduces the extraction voltage to about 50 volts (Step 408). After waiting for the reduction and stabilization of the extraction voltage, the controller 5 energizes a filament and cleans the surface of the electron source (Step 409). After the cleaning, the controller 5 applies the extraction voltage again, on this occasion reads out values of the extraction voltage and the focusing voltage stored in the controller, and controls the power source system so that they may be identical values to the stored them(Steps 410 and 404).

By the method, although once the extraction voltage of the electron gun reduces, the electron source is cleaned, and successively the state where an original extraction voltage is applied is recovered, since an acceleration voltage, the extraction voltage, and the focusing voltage are identical to those before cleaning, a condition of the electron beam is the same as that before the electron source is cleaned and it is unnecessary to readjust the electron gun and the electron optical system. An operator can continue to observe a specimen without being aware of the cleaning of the electron source.

By the control method, an operator does not require the readjustment of the electron gun and the electron optical system and can observe a specimen efficiently for a long period of time. Further, with a controller provided with the control method, it is possible to provide the electron microscope allowing efficient specimen observation to an operator.

Description of the Reference Numerals

1     Electron gun

2     Electron optical system

3     Specimen holder

| | |
|---|---|
| 4 | Detector |
| 5 | Controller |
| 6 | Power source unit |
| 10 | Electron beam |
| 11 | Electron gun vacuum evacuation device |
| 16a | Getter pump |
| 16b | Getter pump |
| 17 | Ion pump |
| 21 | Electron optical system evacuation device |
| 31 | Specimen |
| 61 | Control/detection system power source |
| 62 | Electron gun power source |
| 101 | Electron source |
| 102 | Filament |
| 103 | Extraction electrode |
| 104 | Focusing electrode |
| 105 | Acceleration tube |
| 106 | Intermediate electrode |
| 107 | Intermediate electrode |
| 108 | Intermediate electrode |
| 109 | Intermediate electrode |
| 110 | Anode |
| 120 | Magnetic lens |
| 621 | Extraction power source |
| 622 | Focusing power source |
| 623 | Acceleration power source |
| 624 | Filament heating power source |

**Claims**

1. An electron microscope comprising a magnetic field immersion type electron gun having a magnetic path provided with a permanent magnet around an electron source and having a function of focusing an electron beam emitted from the electron source, is **characterized in that** the electron microscope has a getter pump around the electron source.

2. An electron microscope according to Claim 1, wherein the getter pump is installed inside the magnetic field immersion type electron gun.

3. An electron microscope according to Claim 1, wherein an extraction voltage identical to an extraction voltage applied before cleaning is applied after the electron source is cleaned.

# FIG. 1

## FIG. 2

## FIG. 3

AXIAL MAGNETIC
FIELD STRENGTH

103

120

101    102

# FIG. 4

401
START OF USE

402
FLASHING

403
ACCELERATION VOLTAGE APPLIED

404
EXTRACTION VOLTAGE / FOCUSING VOLTAGE APPLIED

405
EXTRACTION VOLTAGE / FOCUSING VOLTAGE RECORDED

406
START OF OBSERVATION

407
STABILITY DOWN, BRIGHTNESS DOWN

N

Y

408
EXTRACTION VOLTAGE OFF

409
FLUSHING

410
EXTRACTION VOLTAGE / FOCUSING VOLTAGE RECORDED AND READ

5

62

**INTERNATIONAL SEARCH REPORT**

| | International application No. |
|---|---|
| | PCT/JP2011/061403 |

A. CLASSIFICATION OF SUBJECT MATTER
*H01J37/143*(2006.01)i, *H01J37/06*(2006.01)i, *H01J37/073*(2006.01)i,
*H01J37/18*(2006.01)i, *H01J37/26*(2006.01)i

According to International Patent Classification (IPC) or to both national classification and IPC

B. FIELDS SEARCHED

Minimum documentation searched (classification system followed by classification symbols)
H01J37/143, H01J37/06, H01J37/073, H01J37/18, H01J37/26

Documentation searched other than minimum documentation to the extent that such documents are included in the fields searched
Jitsuyo Shinan Koho          1922-1996   Jitsuyo Shinan Toroku Koho   1996-2011
Kokai Jitsuyo Shinan Koho    1971-2011   Toroku Jitsuyo Shinan Koho   1994-2011

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | WO 2005/124815 A1 (Hitachi High-Technologies Corp.),<br>29 December 2005 (29.12.2005),<br>paragraphs [0009] to [0020], [0026] to [0028];<br>fig. 1, 9<br>& JP 4227646 B | 1-2<br>3 |
| Y | WO 2009/153939 A1 (Hitachi High-Technologies Corp.),<br>23 December 2009 (23.12.2009),<br>paragraphs [0025] to [0039]; fig. 3 to 4, 8 to 9<br>(Family: none) | 3 |

☒ Further documents are listed in the continuation of Box C.   ☐ See patent family annex.

*   Special categories of cited documents:
"A"  document defining the general state of the art which is not considered to be of particular relevance
"E"  earlier application or patent but published on or after the international filing date
"L"  document which may throw doubts on priority claim(s) or which is cited to establish the publication date of another citation or other special reason (as specified)
"O"  document referring to an oral disclosure, use, exhibition or other means
"P"  document published prior to the international filing date but later than the priority date claimed

"T"  later document published after the international filing date or priority date and not in conflict with the application but cited to understand the principle or theory underlying the invention
"X"  document of particular relevance; the claimed invention cannot be considered novel or cannot be considered to involve an inventive step when the document is taken alone
"Y"  document of particular relevance; the claimed invention cannot be considered to involve an inventive step when the document is combined with one or more other such documents, such combination being obvious to a person skilled in the art
"&"  document member of the same patent family

Date of the actual completion of the international search
    09 June, 2011 (09.06.11)

Date of mailing of the international search report
    21 June, 2011 (21.06.11)

Name and mailing address of the ISA/
    Japanese Patent Office

Authorized officer

Facsimile No.

Telephone No.

Form PCT/ISA/210 (second sheet) (July 2009)

**EP 2 573 793 A1**

<table>
<tr><td colspan="2">INTERNATIONAL SEARCH REPORT</td><td>International application No.<br>PCT/JP2011/061403</td></tr>
</table>

C (Continuation). DOCUMENTS CONSIDERED TO BE RELEVANT

| Category* | Citation of document, with indication, where appropriate, of the relevant passages | Relevant to claim No. |
|---|---|---|
| A | JP 04-098746 A  (Hitachi, Ltd.),<br>31 March 1992 (31.03.1992),<br>entire text; all drawings<br>& US 5442183 A          & US 5254856 A<br>& EP 462554 A2          & DE 69132441 D<br>& DE 69132441 T | 1-3 |
| A | JP 1-076654 A  (JEOL Ltd.),<br>22 March 1989 (22.03.1989),<br>entire text; all drawings<br>(Family: none) | 1-3 |
| A | JP 2006-294481 A  (Hitachi High-Technologies Corp.),<br>26 October 2006 (26.10.2006),<br>entire text; all drawings<br>& US 2006/0231773 A1 | 1-3 |
| A | JP 2006-324119 A  (Hitachi, Ltd.),<br>30 November 2006 (30.11.2006),<br>entire text; all drawings<br>(Family: none) | 1-3 |

Form PCT/ISA/210 (continuation of second sheet) (July 2009)

**INTERNATIONAL SEARCH REPORT**

| International application No. |
| --- |
| PCT/JP2011/061403 |

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:

    See extra sheet

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.    Consequently, this international search report is restricted to the invention first mentioned in the claims; it is covered by claims Nos.:

**Remark on Protest**        ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

| **INTERNATIONAL SEARCH REPORT** | International application No. |
|---|---|
| | PCT/JP2011/061403 |

Continuation of Box No.III of continuation of first sheet(2)

For the reasons stated below, this international application is considered to contain two inventions which do not satisfy the requirement of unity of invention.

Document 1: WO 2005/124815 A1 (Hitachi High-Technologies Corp.), 29 December 2005, (29.12.2005), paragraphs [0009]-[0020], [0026]-[0028], fig. 1 and 9; JP 4227646 B

Document 1 discloses an invention of "an electronic microscope, which comprises a magnetic field-immersed electron gun that has a magnetic path provided with a permanent magnet around an electron source, while having a function of converging the electron beams generated by the electron source, and which is characterized in that a getter pump is provided around the electron source". The invention of claims 1 and 2 of this international application cannot be considered novel over the invention disclosed in document 1, and thus does not have a special technical feature. Judging from the special technical features of claims 1-3, this international application is considered to contain the following two inventions respectively linked by the special technical features mentioned below.

In this connection, the invention of claims 1 and 2, which does not have a special technical feature, is considered to fall under the group of main invention.

Main invention: claims 1 and 2
Second invention: the inventions which have the technical feature set forth in claim 3 as the special technical feature

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H02297852 A
- JP 2005000916 A